Europäisches Patentamt

European Patent Office

Office européen des brevets

(11) Veröffentlichungsnummer: **0 408 935 A2**

# EUROPÄISCHE PATENTANMELDUNG

(21) Anmeldenummer: **90112136.8**

(51) Int. Cl.5: **H05K 3/22**

(22) Anmeldetag: **26.06.90**

(30) Priorität: **17.07.89 DE 3923627**

(43) Veröffentlichungstag der Anmeldung:
**23.01.91 Patentblatt 91/04**

(84) Benannte Vertragsstaaten:
**AT BE CH DE FR GB IT LI NL SE**

(71) Anmelder: **Siemens Aktiengesellschaft**
**Witteisbacherplatz 2**
**D-8000 München 2(DE)**

(72) Erfinder: **Hacke, Hans-Jürgen, Dipl.-Ing.**
**Malojaweg 7**
**D-8000 München 71(DE)**
Erfinder: **Heiss, Lorenz**

**verstorben(DE)**
Erfinder: **Wirbser, Oscar**
**Kreuzlinger Strasse 73**
**D-8034 Germering(DE)**

(54) **Verfahren und Vorrichtung zum Durchtrennen von Kurzschiussbereichen und Leiterbahnstegen.**

(57) Bei Leiterplatten auftretende Kurzschlüsse können durch Trennen der jeweiligen Kurzschlußbereiche beseitigt werden. Bei nachträglichen Verbindungsänderungen müssen häufig auch Leiterbahnstege (Ls) durchgetrennt werden, um damit verbundene Anschlußflächen (Af2) als Stützpunkte für eine Änderungsverdrahtung heranziehen zu können. In beiden Fällen muß einerseits ein vollständiges Durchtrennen gewährleistet sein, während andererseits eine Beschädigung anderer Teile der Leiterplatten, insbesondere der darunterliegenden Isolierschicht und der darunterliegenden Verdrahtungslage, mit Sicherheit ausgeschlossen werden muß. Dies wird dadurch erreicht, daß ein vorzugsweise aus Hartmetall bestehender Stichel (St) zu Ultraschallschwingungen (US) parallel zur Oberfläche der Leiterplatten (Lp) angeregt wird und daß dann mit dem Stichel (St) spanabhebend Trennfugen (Tf) in die Kurzschlußbereiche oder Leiterbahnstege (Ls) eingebracht werden. Der Vorschub (V) des Stichels (St) verläuft dabei parallel zur Oberfläche der Leiterplatten (Lp), während das Zustellen (Z) stufenweise senkrecht dazu vorgenommen wird.

FIG 1

EP 0 408 935 A2

## VERFAHREN UND VORRICHTUNG ZUM DURCHTRENNEN VON KURZSCHLUSSBEREICHEN UND LEITER-BAHNSTEGEN

Die Erfindung betrifft ein verfahren zum Durchtrennen von Kurzschlußbereichen und Leiterbahnstegen bei Leiterplatten.

Bei Leiterplatten müssen häufig nachträgliche verbindungsänderungen hergestellt werden. Aus diesem Grund sind auf den Außenlagen der Leiterplatten jeweils zwei gegenüberliegende Anschlußflächen durch einen Leiterbahnsteg miteinander verbunden, wobei jeweils eine dieser Anschlußflächen als Stützpunkt für eine spätere Änderungsverdrahtung vorgesehen ist. Ist dann eine Änderung tatsächlich notwendig, so wird der entsprechende Leiterbahnsteg - der in der Praxis häufig auch als Pseudovektor bezeichnet wird - durchgetrennt. In ähnlicher Weise müssen auch Kurzschlußbereiche durchgetrennt werden, die beispielsweise zwischen Leiterbahnen von Innenlagen Kurzschlüsse verursachen. Das Trennen selbst erfolgt dabei durch mechanisches Entfernen der Kurzschlußbereiche oder Leiterbahnstege, beispielsweise durch Abschaben mit Hilfe eines Spezialwerkzeugs. Bedingt durch die manuelle Tätigkeit besteht dabei jedoch die Gefahr, daß die Kurzschlußbereiche oder Leiterbahnstege nicht vollständig durchgetrennt werden oder daß daneben oder darunterliegende Leiterbahnen beschädigt werden. Aus diesem Grunde wurde auch bereits vorgeschlagen, das Durchtrennen mittels Widerstanserwärmung durch entsprechende Stromimpulse vorzunehmen (vergl. IBM Technical Disclosure Bulletin, Band 24, Nr. 12, Mai 1982, Seiten 6383-6384) oder auch Laserstrahlen für den Trennvorgang einzusetzen. Beim Trennen durch Stromimpulse kommt es jedoch häufig zu unerwünschten Unterbrechungen in anderen Leiterbahnbereichen, während das Trennen mit dem Laser zu Schäden an der darunterliegenden Isolierschicht und verdrahtungslage führt.

Der Erfindung liegt die Aufgabe zugrunde, ein Verfahren zum Durchtrennen von Kurzschlußbereichen anzugeben, bei welchem ohne die Gefahr einer Beschädigung anderer Teile der Leiterplatten ein vollständiges Durchtrennen gewährleistet ist. Außerdem soll eine für dieses Verfahren geeignete Vorrichtung zum Durchtrennen von Kurzschlußbereichen und Leiterbahnstegen geschaffen werden.

Diese Aufgabe wird bei einem gattungsgemäßen Verfahren durch die kennzeichnenden Merkmale des Anspruchs 1 und bei einer gattungsgemäßen Vorrichtung durch die kennzeichnenden Merkmale des Anspruchs 5 gelöst.

Der Erfindung liegt die Erkenntnis zugrunde, daß ein zu Ultraschall-Schwingungen angeregter Stichel dann eine äußerst schonende spanabhebende Erzeugung von Trennfugen im Mikrometerbereich ermöglicht, wenn der Schwingungsvektor parallel zur Oberfläche der Leiterbahnen liegt und der Materialabtrag durch stufenweise Zustellung des Stichels senkrecht zur Oberfläche der Leiterplatte vorgenommen wird. Unter Stichel wird hierbei ein spanabhebendes Werkzeug verstanden, daß mit einer meißelartigen Schneide versehen ist und im vorliegenden Fall wie die Sonotrode beim Ultraschall-Schweißen von Metallen zu tangentialen Ultraschallschwingungen angeregt wird.

Gemäß einer bevorzugten Ausgestaltung des erfindungsgemäßen Verfahrens wird ein Stichel verwendet, dessen Schneidenbreite der gewünschten Breite der Trennfuge entspricht. Auf diese Weise wird ohne seitliches Verstellen des Stichels ein Materialabtrag in der gewünschten Fugenbreite erzielt.

Im Hinblick auf einen möglichst feinen und schonenden spanabhebenden Materialabtrag hat es sich auch als günstig herausgestellt, wenn der Stichel senkrecht zur Oberfläche der Leiterplatten stufenweise in Schritten von jeweils 5 bis 10 Mikrometern zugestellt wird.

Gemäß einer weiteren bevorzugten Ausgestaltung des erfindungsgemäßen Verfahrens wird die Zustellbewegung des Stichels derart bemessen, daß die Trennfuge um ein geringes Maß bis unter die Oberfläche der Leiterplatte reicht. Hierdurch ist einerseits eine sichere elektrische Trennung von Kurzschlußbereichen oder Leiterbahnstegen gewährleistet, während andererseits durch eine entsprechend geringe Bemessung der Eindringtiefe in die Isolierschicht unerwünschte Schädigungen ausgeschlossen werden können.

Gemäß einer bevorzugten Ausgestaltung der erfindungsgemäßen Vorrichtung besteht der Stichel zumindest im Schneidenbereich aus Hartmetall. Unter dem Begriff Hartmetall sollen hierbei sowohl gegossene als auch gesinterte Hartlegierungen verstanden werden, die aus einem oder mehreren Hartstoffen wie Wolfram-, Titan-, Tantalcarbid und dergleichen und einem Bindemetall der Eisengruppe, meist Kobalt, aber auch Nickel und Eisen bestehen und sich durch ihre Verschleißfestigkeit und hohe Härte auszeichnen.

Gemäß einer weiteren bevorzugten Ausgestaltung der erfindungsgemäßen Vorrichtung ist der Stichel in einer Querbohrung eines Rüssels des Ultraschallschwingers befestigt. Unter dem Begriff Rüssel wird hierbei wie bei anderen Ultraschall-Verfahren ein Amplitudentransformator verstanden, der durch seine. Formgebung eine Vergrößerung der Schwingungsamplitude des am vorderen Ende befestigten Stichels bewirkt. Der Stichel wird dabei vorzugsweise auswechselbar im Rüssel befestigt, so daß ggfs. auch rasch auf andere Stichel mit anderen Schneidenbreiten umgestellt werden kann und somit verschiedene Trennfugenbreiten erzielt werden können.

Schließlich hat es sich auch als vorteilhaft erwiesen, wenn der aus Ultraschallschwinger, Rüssel und Stichel bestehende Ultraschallkopf um eine senkrecht zur Oberfläche der Leiterplatten verlaufende Achse drehbar ist. Hierdurch können dann auf einfache Weise je nach Lage und Form der zu trennenden Kurzschlußbereiche oder Leiterbahnstege beliebige Richtungen der Trennfugen eingestellt werden.

Ein Ausführungsbeispiel der Erfindung ist in der Zeichnung dargestellt und wird im folgenden näher beschrieben.

Es zeigen:

Fig. 1 in stark vereinfachter schematischer Darstellung die Wirkungsweise einer Vorrichtung zum Durchtrennen von Kurzschlußbereichen und Leiterbahnstegen,

Fig. 2 und 3 eine teilsweise Draufsicht auf eine Leiterplatte mit Bausteinpad, Drahtpad und Pseudovektor vor und nach dem Einbringen einer Trennfuge,

Fig. 4 und 5 eine teilweise Draufsicht auf eine Leiterplatte mit einem Kurzschluß zwischen einer Leiterbahn und einer Durchkontaktierung vor und nach dem Einbringen einer Trennfuge in den Kurzschlußbereich und die

Fig. 6 bis 11 im Querschnitt verschiedene Verfahrensstadien beim Einbringen einer Trennfuge in einen Leiterbahnsteg.

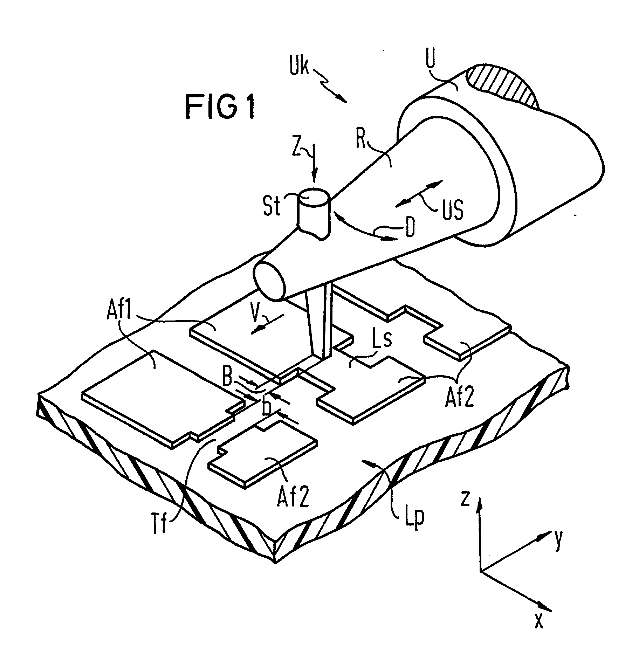

Fig. 1 zeigt in perspektivischer Darstellung Aufbau und Wirkungsweise einer Vorrichtung zum Durchtrennen von Kurzschlußbereichen und Leiterbahnstegen bei Leiterplatten. Da bei der Erläuterung der Wirkungsweise die räumliche Zuordnung einzelner Vorrichtungsteile zu der jeweiligen Leiterplatte eine wesentliche Rolle spielt, ist zur Erleichterung der Bezugnahme ein räumliches x, y, z-Koordinatensystem angegeben. Es ist der vordere Bereich eines insgesamt mit Uk bezeichneten Ultraschallkopfes zu erkennen, der aus einem Ultraschallschwinger U einem Rüssel R, und einem Stichel St besteht. Der nach dem Magnetostriktionsprinzip arbeitende Ultraschallschwinger U trägt den als Amplitudentransformator wirkenden Rüssel R, der wie es durch den Doppelpfeil US aufgezeigt ist - zu Ultraschallschwingungen in y-Richtung angeregt wird. In einer nicht näher bezeichneten Querbohrung im vorderen Ende des Rüssels R ist mit Hilfe einer nicht dargestellten Klemmschraube der auswechselbare Stichel St befestigt. Der in z-Richtung nach unten ragende Stichel St besitzt an seinem unteren Ende eine quer zu den Ultraschall-Schwingungen US ausgerichtete Hartmetallschneide, deren Breite mit B bezeichnet ist. Die Frequenz der Ultraschall-Schwingungen US liegt bei 60 Hz, während die Amplitude der Schwingungen am Stichel St ± 1,5 Mikrometer beträgt. Der Schwingungsvektor des Stichels St liegt parallel zu x, y-Ebene und damit auch parallel zur Oberfläche der entsprechend ausgerichteten Leiterplatten Lp. Die jeweilige Leiterplatte Lp ist lagerichtig zu ihren Seitenkanten in x, y-Richtung ausgerichtet in einer nicht dargestellten Aufnahme angeordnet und in dieser Aufnahme entweder festgespannt oder über Vakuum gehalten.

Auf der Leiterplatte Lp sind jeweils nebeneinander angeordnete Anschlußflächen Af1 und Af2 zu erkennen, die jeweils durch einen Leiterbahnsteg Ls elektrisch leitend miteinander verbunden sind. Zum Durchtrennen der Leiterbahnstege Ls wird nun der um eine in z-Richtung verlaufende Achse drehbare Ultraschallkopf Uk in die gewünschte Bearbeitungsrichtung gedreht, wobei diese Drehung durch einen Doppelpfeil D aufgezeigt ist. Im dargestellten Beispiel entspricht die Bearbeitungsrichtung der y-Richtung. Nach dem Anfahren der Trennstelle, das beispielsweise über einen nicht dargestellten x, y-Tisch vorgenommen wird, erfolgt dann der eigentliche Trennvorgang durch Vorschub V des Stichels St in der hier in y-Richtung verlaufenden Bearbeitungsrichtung und durch stufenweises Zustellen Z des Stichels St in z-Richtung. Der Vorschub V und das Zustellen Z erfolgen hierbei durch entsprechende Bewegungen des Ultraschallkopfes Uk oder aber auch durch entsprechende Bewegungen der Leiterplattenaufnahme. Das Zustellen Z erfolgt in Schritten von 5 bis 10 Mikrometern, während der Vorschub V mit Geschwindigkeiten von 0,5 bis 1,0 m/min erfolgt. Die auf die beschriebene Weise mit dem Stichel St spanabhebend erzeugte Trennfuge im Leiterbahnsteg Ls ist in Fig. 1 mit Tf bezeichnet. Die Breite b der Trennfuge Tf entspricht der Breite B der Stichelschneide, die im dargestellten Ausführungsbeispiel 25 Mikrome ter beträgt. Die beim stufenweisen Einbringen der Trennfuge Tf anfallenden Späne müssen abgesaugt werden. Ferner ist noch zu erwähnen, daß ein Materialabtrag nur beim Vorschub V erfolgt, d.h. beim Rücklauf ist der Stichel St nicht im Eingriff.

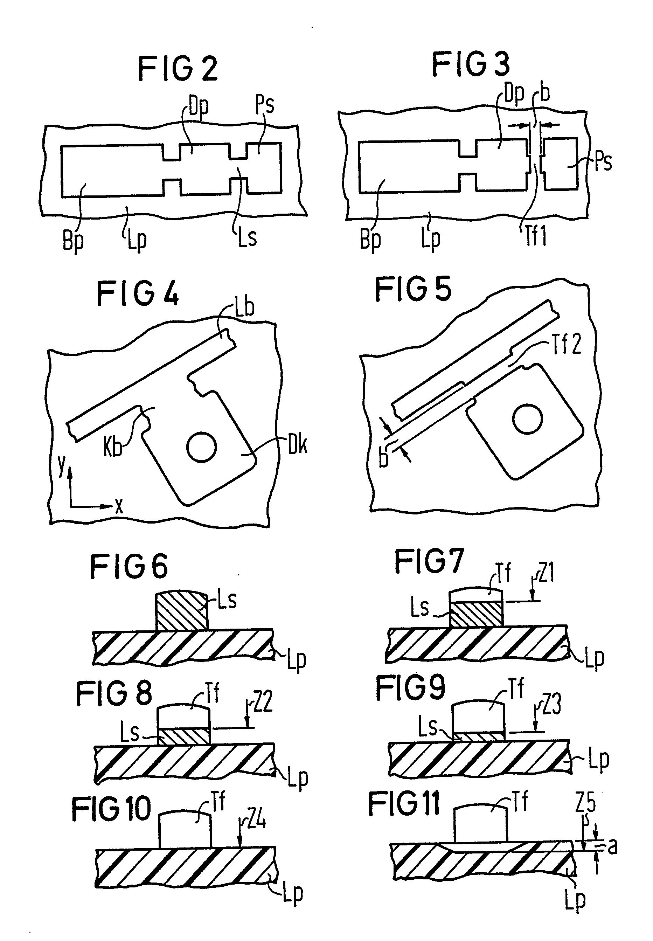

Fig. 2 zeigt eine teilweise Draufsicht auf eine Leiterplatte Lp mit einem Bausteinpad Bp, einem Drahtpad Dp und einem Pseudovektor Ps, die über Leiterbahnstege Ls miteinander verbunden sind. Der Abstand zwischen Drahtpad Dp und Pseudovektor Ps und die Breite des dazwischenliegenden Leiterbahnsteges Ls betragen jeweils 50 Mikrometer. Zum Trennen von Drahtpad Dp und Pseudovektor Ps wird gemäß Fig. 3 in den dazwischenliegenden Leiterbahnsteg Ls eine Trennfuge Tf1 eingebracht, die symmetrisch ausgerichtet ist und eine Breite b von 25 Mikrometern aufweist. Die Schneidenbreite B des zum Trennen verwendeten Stichels St (vergl. Fig. 1) beträgt dementsprechend ebenfalls 25 Mikrometer.

Fig. 3 zeigt eine teilweise Draufsicht auf eine Leiterplatte Lp mit einer Leiterbahn Lb, einer Durchkontaktierung Dk und einem Kurzschlußbereich Kb zwischen Leiterbahn Lb und Durchkontaktierung Dk. Es ist zu erkennen, daß die Leiterbahn Lb sowohl zur x-Achse als auch zur y-Achse geneigt verläuft und daß dementsprechend die Richtung der Ultraschall-Schwingungen US und des Vorschubes V gemäß Fig. 1 durch Drehen des Ultraschallkopfes Uk parallel zur Richtung der Leiterbahn Lb ausgerichtet werden müssen. Der Abstand zwischen Leiterbahn Lb und Durchkontaktierung Dk beträgt 55 Mikrometer. Zur Beseitigung des Kurzschlusses wird gemäß Fig. 5 in den Kurzschlußbereich Kb eine Trennfuge Tf2 eingebracht, die parallel zur Leiterbahn Lb verläuft und eine Breite b von 45 Mikrometern aufweist. Die Scheidenbreite B des zum Trennen eingesetzten Stichels St (vergl. Fig. 1) beträgt dementsprechend hier 45 Mikrometer.

Die Fig. 6 zeigt im Querschnitt einen Leiterbahnsteg Ls einer Leiterplatte Lp der an dieser Stelle vollständig durchtrennt werden soll. Hierzu wird gemäß Fig. 7 die Zustellung Z des Stichels St auf ein Maß Z1 eingestellt, so daß vom Leiterbahn steg Ls beispielsweise 10 Mikrometer abgetragen werden und eine dementsprechend 10 Mikrometer tiefe Trennfuge Tf entsteht. Durch weiteres schrittweises Zustellen Z2, Z3 und Z4 wird gemäß den Fig. 8 bis 10 der Leiterbahnsteg Ls in weiteren 10 Mikrometer-Schritten abgetragen und die Trennfuge Tf bis zur Oberfläche der Leiterplatte Lp vertieft. Um ein sicheres Durchtrennen zu gewährleisten, soll die Trennfuge Tf um ein Maß a von maximal 10 Mikrometern unter der Oberfläche der Leiterplatte Lp verlaufen, wobei die entsprechende zusätzliche Zustellung in Fig. 11 mit Z5 bezeichnet ist. Durch die geringe Größe des Maßes a können unerwünschte Schädigungen der Leiterplatte Lp ausgeschlossen werden.

Es ist noch zu erwähnen, daß die in Fig. 1 im Prinzip dargestellte Vorrichtung für die Einstellarbeiten mit Fernsehkamera und Bildschirm ausgerüstet werden kann. Außerdem ist es zweckmäßig zusätzlich ein Mikroskop anzubringen, mit dem der Trennvorgang beobachtet werden kann. Eine weitere Erleichterung wird dadurch erreicht, wenn auf dem Bildschirm neben der zu trennenden Stelle auch noch eine Markierung mit der Stichelschneide und dem Umriß des herzustellenden Trennfuge zu erkennen ist. Durch manuelles Verfahren in x- und y-Richtung kann dann die zu trennende Stelle Ls oder Kb exakt zu der jeweiligen Markierung positioniert werden.

## Ansprüche

1. Verfahren zum Durchtrennen von Kurzschlußbereichen (Kb) und Leiterbahnstegen (Ls) bei Leiterplatten (Lp),
**dadurch gekennzeichnet,**
daß ein Stichel (St) zu Ultraschall-Schwingunger, (US) parallel zur Oberfläche der Leiterplatten (Lp) angeregt wird und daß dann durch Vorschub (V) des Stichels (St) parallel zur Oberfläche der Leiterplatten (Lp) und durch stufenweises Zustellen (Z) des Stichels (St) senkrecht zur Oberfläche der Leiterplatten (Lp) spanabhebend Trennfugen (Tf;Tf1;Tf2) in die Kurzschlußbereiche (Kb) oder Leiterbahnstege (Ls) eingebracht werden.

2. Verfahren nach Anspruch 1,
**dadurch gekennzeichnet,**
daß ein Stichel (St) verwendet wird, dessen Schneidenbreite (B) der gewünschten Breite (b) der Trennfuge (Tf) entspricht.

3. Verfahren nach Anspruch 1 oder 2,
**dadurch gekennzeichnet,**
daß der Stichel (St) senkrecht zur Oberfläche der Leiterplatten (Lp) stufenweise in Schritten von jeweils 5 bis 10 Mikrometern zugestellt wird.

4. Verfahren nach einem der vorhergehenden Ansprüche,
**dadurch gekennzeichnet,**
daß die Zustellbewegung des Stichels (St) derart bemessen wird, daß die Trennfuge (Tf) um ein geringes Maß (a) bis unter die Oberfläche der Leiterplatte (Lp) reicht.

5. Vorrichtung zum Durchtrennen von Kurzschlußbereichen (Kb) und Leiterbahnstegen (Ls) bei Leiterplatten (Lp),
**gekennzeichnet durch**
- einen an einen Ultraschallschwinger (U) angekoppelten Stichel (St), wobei
- der Schwingungsvektor des Stichels (St) parallel zur Ober fläche der Leiterplatten (Lp) liegt,
- Stichel (St) und Leiterplatten (Lp) senkrecht zur Oberfläche der Leiterplatten (Lp) relativ zueinander stufenweise verstellbar sind und
- Stichel (St) und Leiterplatten (Lp) parallel zur Oberfläche der Leiterplatten (Lp) relativ zueinander verfahrbar sind.

6. Vorrichtung nach Anspruch 5,
**dadurch gekennzeichnet,**
daß der Stichel (St) zumindest im Schneidenbereich aus Hartmetall besteht.

7. Vorrichtung nach Anspruch 5 oder 6,
**dadurch gekennzeichnet,**
daß der Stichel (St) in einer Querbohrung eines Rüssels (R) des Ultraschallschwingers (U) befestigt ist.

8. Vorrichtung nach Anspruch 7,
**dadurch gekennzeichnet,**
daß der Stichel (St) im Rüssel (R) auswechselbar befestigt ist.

9. Vorrichtung nach einem der Ansprüche 5 bis 8,
**dadurch gekennzeichnet,**
daß der aus Ultraschallschwinger (U), Rüssel (R)
und Stichel (St) bestehende Ultraschallkopf (Uk)
um eine senkrecht zur Oberfläche der Leiterplatten
(Lp) verlaufende Achse drehbar ist.

FIG 1

FIG 2

FIG 3

FIG 4

FIG 5

FIG 6

FIG 7

FIG 8

FIG 9

FIG 10

FIG 11